# EUROPEAN PATENT SPECIFICATION

(11) **EP 3 933 882 B1**
(45) Date of publication and mention of the grant of the patent: **02.09.2026**
(21) Application number: 20183384.5
(22) Date of filing: 01.07.2020
(51) Int. Cl.: H10P 95/00

(54) **APPARATUS AND METHOD FOR ATOMIC LAYER PROCESSING**
VORRICHTUNG UND VERFAHREN ZUR ATOMLAGENVERARBEITUNG
APPAREIL ET PROCÉDÉ POUR LE TRAITEMENT DE COUCHES ATOMIQUES

(43) Date of publication of application: 05.01.2022
(73) Proprietor: Carl Zeiss SMT GmbH, 73447 Oberkochen (DE); Nederlandse Organisatie voor toegepast- natuurwetenschappelijk Onderzoek TNO, 2595 DA 's-Gravenhage (NL)
(72) Inventor: ROOZEBOOM, Fred, 5656 AE Eindhoven (NL); EHM, Dirk Heinrich, 66701 Beckingen (DE); BECKER, Moritz, 73430 Aalen (DE); SCHMIDT, Stefan Wolfgang, 73431 Aalen (DE); CREIJGHTON, Yves Lodewijk Maria, 2611 VX Delft (NL); SMELTINK, Jeroen, 5656 AE Eindhoven (NL); EIJNDEN, Edwin van den, 5656 AE Eindhoven (NL)
(74) Representative: Kohler Schmid Möbus Patentanwälte

(56) References cited:
- EP-A1- 2 960 358
- WO-A1-2019/007927
- US-A1- 2018 265 970
- POODT PAUL ET AL: "Low temperature and roll-to-roll spatial atomic layer deposition for flexible electronics", JOURNAL OF VACUUM SCIENCE AND TECHNOLOGY: PART A, AVS /AIP, MELVILLE, NY., US, vol. 30, no. 1, 1 January 2012 (2012-01-01), pages 1A142 - 1A142, XP012160355, ISSN: 0734-2101, [retrieved on 20111209], DOI: 10.1116/1.3667113
- HENSELMANS ET AL: "Design of a machine for the universal non-contact measurement of large free-form optics with 30 nm uncertainty", PROCEEDINGS OF SPIE - OPTICAL MANUFACTURING AND TESTING VI, vol. 5869, 4 August 2005 (2005-08-04), pages 5869191 - 58691912, XP040207665

## Description

### Background of the invention

The invention relates to an atomic layer processing apparatus for spatial atomic layer processing of an optical surface of an optical element that is preferably configured to reflect EUV radiation. The atomic layer processing apparatus comprises: a processing chamber and at least one processing head configured for atomic layer processing of the optical surface of the optical element within the processing chamber. The at least one processing head is suitable for performing atomic layer processing of a curved optical surface of the optical element. The invention also relates to a method for atomic layer processing of an optical surface of an optical element that is preferably configured to reflect EUV radiation. The term "atomic layer processing" as used herein is a generic term that covers atomic layer etching (ALE) and atomic layer deposition (ALD).

The removal of minute but detrimental metal and other silicon, phosphorus, sulfur-related traces on functional substrates used in high-end manufacturing equipment usually requires long clean-treatment times and, in addition, unnecessary down-time of the production equipment involved. An ultimate example are EUV-lithography systems that employ Multilayer-Mirror (MLM) stacks (e.g. more than 30 Mo/Si bilayers) in EUV reflection optics as optical elements configured to reflect EUV radiation. The MLM stacks are capped with protective layers to uphold the stack's EUV reflectivity that is at best 70% and decreases even at monolayer coverage of the optical surface (mirror surface) with contaminating nanoclusters of Sn from the EUV plasma source, as well as C, Si, P, S, Zn, Pb and the like from the lithography system and the semiconductor process wafers. Evidently there are many more metal/metalloid contaminants that may be critical in ultrapure manufacturing environment (e.g. Cu, Ag, In, ...) also in other domains than semiconductor manufacturing that can bring machine performance down and lead to increased machine downtime for refurbishing.

Especially on the EUV collector mirror, closest to the EUV plasma source that releases Sn ions and neutrals or compounds, this degradation is detrimental for high wafer throughput. As an example, the lead time for *ex-situ* current cleaning including demounting and remounting plus re-alignment of the most vulnerable EUV-mirror, the collector, can take typically more than 3 months.

For removing contaminants from the optical surface, wet etch techniques have been described using a cleaning tank with acid solution like hydrochloric acid (HCl), see e.g. US 9,073,098, or possibly a wide variety of other acids, see e.g. WO 2013/159928 A1. The stripping of layer pairs or of the entire multilayer coating of an EUV collector mirror for refurbishment has been described in the article "Lifetime and refurbishment of multilayer LPP collector mirrors", T. Feigl et al., Proc. SPIE 8679, 86790C (2013).

However, preferred EUV cleaning methods are dry processes based on exposure of the contaminated substrates in vacuum vessels e.g. to soft-sputter etching ambients, for example with focused ion beams (FIBs).

For removing contaminants from EUV optics in a dry process, hydrogen radicals can be used, see e.g. US 7,598,503 B2, US 7,459,708 B2, the article "Atomic-hydrogen cleaning of Sn from Mo/Si and DLC/Si extreme ultraviolet multilayer mirrors", J. of Micro/Nanolithography, MEMS, and MOEMS, 11(2), 021118 (2012), or the article "Sn etching with hydrogen radicals to clean EUV optics", M.M.J.W. van Herpen et al., Chem. Phys. Lett., 484 197 (2010). In the latter article, a method to clean EUV optics from Sn contaminations is described, making use of an intermediate "cleaning cap" layer between the Sn contaminants and the Ru cap layer.

Hydrogen radicals can be generated in a continuous process by passing H₂-gas along a hot wire before it enters the reaction vessel (see e.g. US 7,812,330 B2 or DE 10 2009 045 170 A1), by producing a hydrogen plasma using RF waves, see e.g. the article "Collector optic in-situ Sn removal using hydrogen plasma", J.R. Sporre et al., J. Vac. Sci. Technol., A 34, 021305 (2016), or by creating the hydrogen radicals on the collector surface by using the collector itself to drive a capacitively coupled hydrogen plasma, see e.g. the article "In situ collector cleaning and extreme ultraviolet reflectivity restoration by hydrogen plasma for extreme ultraviolet sources", D. Elg et al., J. Vac. Sci. Technol., A 34, 021305 (2016).

EP1364231 B1 discloses a method for maintaining a surface of a reflective optical element used in EUV lithography applications substantially free of carbon contamination. The method includes the steps of: supplying a reactive gas, and exposing a capping metal layer, e.g. Ru, to EUV radiation, thereby generating electrons that react with the reactive gas, e.g. O₂, H₂, H₂O, to generate reactive atomic species that in turn react with carbon contaminants deposited on the capping layer surface.

When using hydrogen radicals (H*), the Sn, Zn, Pb, C, P, S, and Si contaminants form volatile hydrides based on the following chemical reaction (e.g. of Sn) on the optical surface:

Sn (s) + 4 H* (g) → SnH₄ (g).

These volatile hydrides can be pumped off and removed from the environment of the optical surface.

Another a bit more exotic dry method for cleaning the surfaces of EUV optics makes use of the tin pest, i.e. of the allotropic β-Sn → α-Sn phase transformation at 13.2° C, see e.g. the article "Introduction of tin pest for cleaning tin-drop contaminated optics", N. Böwering, Materials Chemistry and Physics 198 236 (2017), and the article "In situ transformation and cleaning of tin-drop contamination on mirrors for extreme ultraviolet light", N. Böwering et al., J. Vac. Sci. Technol., A 36, 021602 (2018), where α-Sn (grey tin, which is a brittle semimetal) droplets are inoculated as seeds for the tin pest induced embrittlement into pieces of powder of the ductile β-Sn (white tin) phase, especially in combination with temperatures below the allotropic Sn phase transformation, e.g. at a temperature of -24°C or in a temperature range between -25°C and -40°C.

In the cleaning methods described above, often an additional Focused Ion Beam (FIB) post-treatment is used to locally remove the most resilient nano-clustered contaminants. This procedure typically requires a feed-back loop using layer thickness scanning and re-scanning.

It should be noted that most *ex-situ* cleaning processes require the contaminated object to be demounted from the cleaning reactor chamber (e.g. an EUV mirror from a lithography system) and placed in a larger reactor volume that can accommodate the entire contaminated object. Esp. for wet cleaning processes also the optical collector surface has to be disconnected from the mechanical support frames because the mechanical materials cannot withstand the cleaning environment. Such large volumes hamper efficient and uniform supply of chemical reagents and removal of by-products in most of the cleaning methods described above, e.g. in wet-cleaning, soft-sputtering, and hydrogen-radical assisted continuous processing. Thus, all of these etch methods will not yield the conservation of layer uniformity which is needed to maintain uniform reflectivity upon re-use.

More specifically, the wet etch method will suffer from purity control, since one has to clean in bulky chemical tanks with stirring, etc., the sputter method may cause (ion-induced) damage of the substrate surface, and the cleaning methods using hydrogen radicals are a continuous process without the self-limiting characteristics offered by atomic layer processing and thus with potentially less uniformity control. Finally, the proposed approach using the tin pest is a low-temperature process that requires strict temperature uniformity specifications over large surfaces at temperatures below -20°C.

The deficiencies of the cleaning methods described above may be overcome by using atomic layer processing, e.g. cleaning/etching by Atomic Layer Etching (ALE) possibly combined with passivation deposition, see e.g. the article "Cyclic etch/passivation-deposition as an all-spatial concept towards high-rate room temperature Atomic Layer Etching", F. Roozeboom et al., ECS Journal of Solid State Science and Technology, 4 (6), N5067-N5076 (2015). For performing spatial ALE, an atomic layer etching head can be used, which may be moved relative to the optical surface, as is described by way of example in US 9,761,458 B2. Atomic layer processing may also be used for protecting optical elements by depositing a cap layer of an optical element for reflecting EUV radiation by Atomic Layer Deposition (ALD), in particular by spatial ALD, see e.g. DE 10 2017 213 172 A1.

US 8,147,647 B2 discloses a method and an arrangement for *in-situ* cleaning of optical surfaces in plasma-based radiation sources. In the method, gas radicals are generated by dielectrically impeded discharge between two surface electrodes along the entire optical surface to be cleaned.

WO 2019/007927 A1 discloses a method for at least partially removing a contamination layer from an optical surface of an optical element by an atomic layer etching process. The ALE process may be a spatial atomic layer etching process that uses an atomic layer etching head. The atomic layer etching process comprises exposing the contamination layer to a surface-modifying reactant in a surface modification step, and exposing the contamination layer to a material-detaching reactant in a material detachment step. In one variant, a redox-cycle may be performed using oxygen as the surface-modifying reactant and hydrogen as the material-detaching reagent. In another variant, an organic compound, e.g. a β-diketone, in particular acetylacetone, is used as the surface-modifying reactant and oxygen is used as the material-detaching reactant.

In addition to the cleaning of optical surfaces by removing contaminating substances, the (dynamic) deposition of protective layers is also possible. EP1522895B1 discloses a method of supplying a dynamic protective layer to at least one mirror to protect the at least one mirror from etching by ions. The method includes supplying a gaseous matter, e.g. a gaseous hydrocarbon, to a chamber containing the at least one mirror.

### Object of the invention

It is an object of the invention to specify an apparatus and a method of the type mentioned in the introductory part, which have the lowest possible damaging influence on the reflective optical element and allow in particular the removal of contaminating materials that adhere strongly to the optical surface.

### Subject matter of the invention

According to a first aspect, this object is achieved by an apparatus of the type described in the introductory part, wherein the atomic layer processing head comprises a curved surface having a geometry that is adapted to the curved optical surface of the optical element.

In the context of the present application a curved (optical) surface designates both (non-planar) surfaces that have a constant curvature and surfaces that has a position-dependent curvature, such as free-form. In a relevant case described herein, the curved optical surface has a rotational symmetry. In particular, the curved optical surface may be an ellipsoid of revolution, as is typically the case with the optical surface of an EUV collector mirror of an EUV lithography system.

The inventors have found that the optical elements of an EUV lithography system that are most critical with respect to degradation typically have curved optical surfaces. This applies especially to the collector mirror that is closest to the plasma source and whose degradation is detrimental for high wafer throughput. Customary processing heads for ALE processing are configured for performing atomic layer processing of flat surfaces, e.g. of a wafer. However, these processing heads are not suitable for ALE processing of curved optical surfaces, especially when the curvature of the surface is considerable, having a curvature radius of e.g. less than 500 mm. In this respect, it should be noted that the processing head, more specifically the surface of the processing head where the gas injection channels terminate, should be kept at close proximity to the optical surface of the optical element. In the present context, close proximity refers to a distance between the processing head and the curved optical surface of typically 300 µm or less.

In one embodiment the apparatus is adapted to keep a distance of the at least one processing head from the curved optical surface in a distance range of between 20 µm and 300 µm, preferably of between 20 µm and 200 µm, during the atomic layer processing. In this embodiment, the apparatus is adapted to automatically keep the distance between the processing head and the curved surface within the above-described distance range. For this purpose, the apparatus typically comprises a control device acting on at least one actuator for the processing head, typically taking a distance measuring result of at least one sensor for measuring the distance between the processing head and the curved surface of the optical element into account. The sensors and/or actuators may be integrated into the processing head and may be dynamically controlled to keep the distance in the range described above, resp., to keep the distance constant. By keeping the processing head in close proximity to the curved surface, a more efficient and uniform removal of the contamination can be provided as compared to conventional ALE where the object to be processed would be treated in a bulky reactor in a far less efficient process. Such a large reactor volume would hamper efficient and uniform supply of chemical reagents and removal of by-products even in conventional ALE.

The atomic layer processing apparatus is configured for performing spatial atomic layer processing of the curved optical surface. In spatial atomic layer etching ("spatial ALE") which is also known as "fast" ALE, as well as in spatial atomic layer deposition ("spatial ALD"), the process steps or rather the process gases of the process steps of ALE/ALD are performed in close proximity to the surface of curved optical surface of the optical element in zones or regions which are spatially separated from one another. For this purpose, an atomic processing head can be used, which is moved relative to the surface. Processing heads for performing spatial ALE/ALD on planar surfaces are described by way of example in US 9,761,458 B2 or in DE 10 2014 222 534 A1.

Unlike conventional atomic layer processing, spatial atomic layer processing is generally performed at or close to atmospheric pressure. For this reason, the pressure in the processing chamber may set to be at or close to atmospheric pressure. Unlike conventional atomic layer processing, in spatial atomic layer processing, the reactor volume is confined to the gap between the processing head and the (curved) optical surface. The environment in close proximity of the interspace or (concentric) gap between the processing head and the optical surface may be flushed with an inert gas, e.g. nitrogen. The inert gas provides an enclosure or gas curtain that prevents any back-diffusion of outside air into the concentric gap between the substrate and the processing head.

The atomic layer processing head comprises a curved surface having a geometry that is adapted to the curved optical surface of the optical element, the curved surface having preferably a rotational symmetry with respect to an axis of revolution. In this case, the surface of the injection head that is arranged opposed to the curved surface of the optical element has a geometry (or contour shape) that is adapted to (or coincides) with the geometry (or contour shape) of the curved optical surface. The curved optical surface of the optical element and hence the curved surface of the processing head may be a free-form surface. However, it is preferable when the curved surface of the processing head and also the curved optical surface have an axis of rotation, i.e. both are rotation symmetric surfaces, as a rotational symmetry facilitates the spatial layer processing (see below). In the present embodiment, the curved surface of the processing head typically covers a surface area that is at least one fourth, preferably at least half of the area of the curved optical surface. It is also possible that the curved surface of the processing head spans the entire curved surface of the optical element.

In a further development, the apparatus is configured to rotate the atomic layer processing head and the curved surface of the optical element relative to each other. The relative movement of the atomic layer processing head relative to the curved surface may be achieved by rotating the processing head and keeping the arrangement of the optical element within the processing chamber fixed, by rotating the optical element within the processing chamber and keeping the processing head fixed, or by both rotating the processing head and the optical element within the processing chamber. It will be understood that in order to keep the curved surface of the processing head and the curved optical surface in close proximity to each other, a rotational symmetry of both surfaces is beneficial. However, it may also be possible to perform spatial atomic layer processing when only part of the optical surface is rotationally symmetric by rotating the optical surface and the surface of the atomic layer head relative to each other. When rotating the surface of the atomic layer head and the optical surface relative to each other, the respective axes of revolution of these two surfaces may coincide.

In a further development, the apparatus is configured to tilt the curved surface of the atomic layer processing head relative to the curved surface of the optical element. In this development, the axis of revolution of the surface of the processing head is tilted relative to the axis of revolution of the optical surface. Both axes typically coincide at an intersection point on the optical surface (or in close proximity thereof). In the present embodiment, typically the atomic layer processing head is tilted relative to the (fixed) optical element. Nevertheless, it is also possible that the optical element is rotated (and tilted) while the atomic layer processing head is stationary.

In one embodiment, the atomic layer processing head comprises at least one of slit-shaped gas injection channels and slit-shaped gas exhaust channels. The slit-shaped gas injection channels and/or gas exhaust channels typically have a length that spans (almost) the entire extension of the processing head. The slit-shaped gas injection/exhaust channels are typically arranged parallel to each other. The slit-shaped injection/exhaust channels may extend from an end of the processing head close to the surface of the processing head to a remote end thereof either in a linear manner or in a curved manner. The slit-shaped (or possibly differently shaped) gas injection or gas exhaust channels may be micro-machined or generated by 3D-printing.

The processing head may comprise plasma generating elements to assist the processing. The gases needed for the processing are typically fed to inlet sections of an injector assembly that is arranged a distal end of the processing head and will not be described in greater detail herein.

It is not necessary that the slit-shaped gas injection/exhaust channels are distributed across the entire processing head. Rather, the gas injection/exhaust channels may be limited to a specific region of the processing head. Also in this case, the entire optical surface of the optical element may be processed by the processing head by rotating the processing head and the optical surface relative to each other.

In a further embodiment, the atomic layer processing head comprises a plasma source having an array of slit-shaped (or possibly differently shaped) plasma-activated gas injection channels. In such a plasma source, typically, a number N of typically slit-shaped or slit-like plasma-activated gas injection channels alternates with a number N+1 of gas exhaust channels, N ranging e.g. from 1 to 10. Using a number of e.g. four or more slit-shaped plasma-activated gas injection channels allows to provide a wide-area remote plasma source, allowing an exposure width that is larger than achievable with a single plasma-activated gas injection channel, thus allowing far more effective plasma steps. The plasma source having an array of plasma-activated gas injection channels and an interleaved array of gas exhaust channels may nevertheless be limited in its lateral extent to a region of the processing head that is comparatively small, e.g. about 10-30 mm.

The plasma-activated gas injection channels can be embodied e.g. as Dielectric Barrier Discharge (DBD) plasma sources: In this case, the plasma-activated gas injection channels are surrounded by two dielectric plates made of ceramic material such as Al₂O₃ or glass. The dielectric plates with embedded electrodes, e.g. in the form of film electrodes, can be manufactured by using low temperature or high temperatures co-firing techniques (abbreviated as LTCC or HTCC). The dielectric material covering the embedded film electrodes forms a dielectric barrier, allowing for non-thermal plasma formation of the material-detaching reactant or possibly of the surface-modifying reactant passing through the intermediate space between the ceramic plates. In operation, the electrodes are coupled to a power supply (not shown) generating an oscillating or repetitively pulsed voltage. For creating an effective plasma-enhanced gas mixture, e.g., molecular oxygen or hydrogen is admixed with an inert carrier gas such as N₂, Ar, He, and Xe.

A further important benefit of this new type of slit-array plasma source is the insertion of a manifold of interleaved slit-shaped gas exhaust channels, allowing for effective removal of reaction products. This will reduce the re-dissociation of volatile reaction products such as SnH₄, Sn(AcAc) and hydrocarbons and thus avoid re-deposition of the metal and carbonaceous contaminant species.

In an embodiment not according to the invention, the atomic layer processing head has an end portion (tip portion) with an end surface where at least one gas injection channel and at least one gas exhaust channel terminate, and the apparatus is configured to move the end portion of the atomic layer processing head relative to the curved optical surface of the optical element in a scanning manner, preferably with at least four, in particular with five degrees of freedom. In the present embodiment, the end portion of the processing head is comparatively small and the atomic layer processing of the entire optical surface is performed by moving the end portion of the processing head in a scanning manner across the optical surface. The scanning movement typically includes at least two translational degrees of freedom and at least one, preferably two, rotational degrees of freedom. The end portion of the processing head typically comprises at least three gas exhaust channels and at least two gas injection channels, each of the gas injection channels being arranged between two neighbouring gas exhaust channels.

The degrees of freedom may be distributed between the end portion of the processing head and the optical element, resp., the holder of the optical element. For instance, the processing head may be movable in two directions with a translational movement and the end portion of the processing head may have an additional rotational degree of freedom relative to a base body of the processing head. Such a configuration is especially suitable when the curved surface of the optical element has a rotational symmetry about a central axis of rotation. In this case, the optical element, or rather the holder of the optical element, may have one additional rotational degree of freedom. The translational and rotational degrees of freedom can be realized with the aid of corresponding (numerically controlled) translational drives and rotational drives acting on the processing head and the holder of the optical element, respectively.

In one development, not according to the invention, the end portion of the atomic layer processing head is tiltable relative to the curved surface of the optical element, preferably with at least two rotational degrees of freedom (i.e. two angles of rotation). It is also possible that the end portion of the processing head can be moved with five degrees of freedom relative to the (static) optical element. In this case, the processing head is typically mounted in the processing chamber so that it may be translated in three mutually orthogonal directions. In this case, the end portion of the processing head typically has two rotational degrees of freedom relative to a base body of the processing head. The rotational degrees of freedom may be realized by using e.g. two mutually orthogonal rotation axes or three actuators (e.g. Lorentz actuators) that act on three points or arms of the end portion and that allow controlled rotation of the end portion of the processing head with two rotational degrees of freedom.

The processing head may be configured in a similar way as a non-contact metrology tool for precise measurement of the surface form of freeform surfaces, see e.g. "http://www.tno.nl/media/2662/nanomefos-leaflet.pdf". The processing head for the atomic layer processing may be based on such a metrology tool. However, in contrast to such a metrology tool, the end portion of the processing head described herein comprises gas inlet channels and gas exhaust channels for performing the atomic layer processing.

If necessary, the *subtractive,* ALE-based cleaning process can be extended to or interrupted by an *additive* ALD-based process to refurbish (e.g. Ru deposition) or improve the substrate surface protection layer (e.g. SiO₂ cap layer) using the relevant chemical vapors in the same equipment. In this way, the approach described above implies truly integrated Atomic Layer Processing.

The atomic layer processing apparatus may in particular comprise two or more atomic layer processing heads having an end portion that can be moved relative to the curved optical surface in a scanning manner. In this way, the throughput may be increased.

In the combined approach described above, one of the two processing heads may be used for atomic layer etching and the other processing head may be used for atomic layer deposition. However, it will be understood that both ALE-based processes and ALD-based processes may be performed with one and the same processing head.

In one development, not according to the invention, the end portion of the atomic layer processing head has an end surface having a width of less than 5 mm. The end surface of the end portion may be a planar surface where the gas injection channels and the gas exhaust channels terminate. An end surface having a comparatively small surface area is advantageous to process curved surfaces having a relatively large radius of curvature. For example, an end surface having a diameter in the order of 5 mm typically allows processing of curved surfaces having a radius of curvature of more than 50 mm. It should be noted that the term "diameter" refers to the maximum lateral extent of the end surface, i.e. the end surface does not need to have a circular geometry. It will also be understood that an appropriate choice for the diameter of the end surface depends on the minimal gap width and the nominal gap width of the gap between the end surface and the curved optical surface, as well as on the minimum radius of curvature of the optical surface that should be processed with the processing head.

In a further embodiment, the apparatus further comprises: at least one sensor for determining an orientation and/or a distance between the processing head and the curved surface of the optical element. The at least one sensor may be integrated into the processing head, but it may also be arranged at another location in the apparatus. The sensor(s) may be optical sensors. For instance, in order to determine the orientation and the distance between the processing head (or the end portion thereof) and the curved optical surface, three optical sensors may be provided, each performing a distance measurement to the curved optical surface by directing a measuring beam to the optical surface. By using three such measurement beams, the distance and the orientation (two angles of rotation) of the processing head relative to the curved optical surface may be determined.

In a further embodiment, the apparatus further comprises: at least one actuator for adjusting an orientation and/or a distance between the processing head and the curved surface of the optical element. The actuators may be e.g. Lorentz force actuators that act on (folded) leaf springs to perform rotation of the end portion with two degrees of freedom. Alternatively, the actuators may be rotary drives that allow rotating the end portion about two (typically orthogonal) rotation axes relative to the base body of the processing head.

A further aspect of the invention relates to a method for atomic layer processing of an optical surface of an optical element, preferably configured to reflect EUV radiation, comprising: performing an atomic layer etching process for removing contaminants from a curved optical surface of the optical element in an atomic layer processing apparatus as described above, wherein the atomic layer etching process comprises: exposing the contamination layer to a surface-modifying reactant in a surface modification step, and exposing the contamination layer to a material-detaching reactant in a material detachment step.

In this aspect of the invention, it is proposed to use an atomic layer etching process to remove contaminants such as Sn contaminants that typically cannot be removed from an optical surface of a reflective optical element by conventional cleaning methods, e.g. by cleaning with atomic hydrogen alone.

In an atomic layer etching process, an alternating sequence or a cycle of two process steps (A/B/A/B/...), of three process steps (A/B/C/A/B/C/...) or of more process steps is performed. In the case of two process steps, a first step represents a surface modification step and a temporally subsequent second step represents an etching or material detachment step. The two or possibly more successive steps can be performed one after another in one and the same process reactor (conventional ALE method).

In the surface modification step, the reflective optical element, or specifically at least the optical surface with the contaminants, is exposed to a/at least one surface-modifying reactant, also referred to as a chemical precursor, which changes the surface of the contamination layer. The change can be effected for example by chemisorption, i.e. by the formation of chemical bonds between the precursor and the contaminants or by a (pre-) oxidation of chemical elements such as Sn, etc., which has a lower surface energy in the oxidized state than metallic Sn, which means that SnOₓ is easier to detach than metallic Sn.

After the first step, i.e. the surface modification step, the excess precursor or the surface-modifying reactant are removed from the process reactor, specifically generally pumped off or flushed away. In the second, material-detachment step, the optical surface with the contaminants is typically exposed to a/at least one material-detaching reactant in the form of a high-energetic species (free radicals, ions, photons) that detaches the chemically weakened contaminants. For example, hydrogen radicals or hydrogen ions, as reducing species, can effect a reduction of the surface that was (pre-) oxidized in the previous, first step or of the materials present there. In this way, the (pre-)oxidized material is detached and can pass into the chamber of the process reactor. The waste products formed here are removed from the chamber of the process reactor after the second step is complete, typically by extracting them by suction or by purging the chamber.

The atomic layer etching process is in general performed in an atomic layer processing apparatus. The atomic layer processing apparatus can be, for example, a conventional apparatus configured for atomic layer etching or for reactive ion etching, which includes a process reactor or a process chamber in which the atomic layer etching process is performed. The two process steps which were described further above are repeated multiple times in such a process chamber until the contaminants are at least partially, generally completely stripped away. The atomic layer etching process in the process chamber makes possible a gentle treatment of the optical element, because in one cycle, i.e. in two process steps, only a very small number of layers or of contaminants are stripped away. However, for atomic layer processing of curved optical surfaces, such a conventional ALE process is typically not suitable (see below).

In one variant, the atomic layer processing further comprises: performing an atomic layer deposition process for depositing material on the curved optical surface of the optical element. In this case, the ALE-based cleaning process is extended or interrupted by an ALD process to refurbish the optical element by material deposition using the relevant chemical vapours (reactants), typically in one and the same atomic layer processing apparatus. As is the case with the ALE process, the ALD process also involves an alternating sequence or a cycle of two or more process steps. In each process step, the optical surface is exposed to a different reactant. For instance, in an ALD process with a cycle of two process steps, the optical surface is exposed in a respective first process step with a first reactant and in a respective second process step with a second reactant. In the atomic layer deposition process, material such as Ru may be deposited on the optical surface to provide a capping layer / protection layer for the optical element. The integrated solution described above enables ALD and ALE of thin films of curved surfaces, used e.g. for deposition and/or cleaning of protection layers or layer stacks on EUV collector mirrors.

In particular, the integrated approach allows for complete refurbishing of degraded EUV collector mirrors after end-of-life operation in EUV high-volume manufacturing. Such a collector mirror typically is elliptically-axisymmetric shaped and has a concave optical surface. The typical diameter of the optical surface is more than 0.5 m with a central recess (hole) having a diameter of about 120mm-150mm. The curved optical surface typically has a height of about 200 mm measured along the axis of revolution of the EUV collector mirror.

In one variant, the atomic layer etching process is performed as a spatial atomic layer etching process, and preferably the atomic layer deposition process is performed as a spatial atomic layer deposition process. Both the ALE process and the ALD process are preferably assisted by a plasma. In spatial atomic layer etching ("spatial ALE"), or spatial atomic layer deposition ("spatial ALD") which is also known as "fast" ALE or "fast" ALD, respectively, the two process steps or rather the process gases of the two process steps are conducted/guided over and in close proximity of the curved surface of the reflective optical element in zones or regions which are spatially separated from one another. For this purpose, an atomic layer processing apparatus being an integrated spatial ALD-ALE reactor may be used. The apparatus may comprise at least one atomic layer processing head that is moved relative to the curved optical surface, as described further above.

In the following, the ALE process will be described in greater detail for the example of Sn as a contaminant. However, the ALE process may be applied to other metals and metalloids that can be mildly oxidized and reduced into volatile hydrides, fluorides, chlorides, oxychlorides, metallocenes, etc. This holds especially for the elements from the carbon group (group IV) in the so-called p-block (C, Si, Ge, Sn, Pb) and for some transition elements (e.g., Zr, V).

In a further variant, a first surface modification step using oxygen as the surface-modifying reactant and preferably a first material detachment step using hydrogen as the material-detaching reactant are performed in the atomic layer etching process. Such a surface modification step, in which the material on the surface of the contamination layer is at least partially oxidized, is typically followed by a reduction step, in which the material, which was oxidized in the previous step, is reduced in the following step for example using hydrogen as the process gas for detaching the material from the surface. The first surface modification step and the first material detachment step form a first cycle (redox cycle) of the atomic layer etching process.

Such a redox cycle can be used advantageously in particular in an atomic layer etching process in which the contaminants contain tin (Sn) as the contaminating material, and plasma-assisted ALE is performed: The O*-plasma or O* radicals in the surface modification step serve to redistribute the contaminating Sn-film or layer by (pre-oxidizing) and subsequently reducing the Sn, e.g. as follows:

Sn (s) + x O* (g) → SnOₓ (s)

and

SnOₓ (s) + 2 H* → Sn (s) + x H₂O.

In the following (first) material detachment step, hydrogen, or more specifically, a hydrogen plasma H* is used as the material-detaching reactant and serves to remove the Sn by conversion into the volatile stannane:

Sn (s) + 4 H* (g) → SnH₄ (g) .

In a further variant, in the atomic layer etching, a second surface modification step using a chemical complexing agent, preferably using an organic compound, more preferably using a β-diketone, in particular acetylacetone, as the surface-modifying reactant and preferably a second material detachment step using oxygen as the material-detaching reactant are performed in the atomic layer etching. The second surface modification step and the second material detachment step form a second cycle of the atomic layer etching process.

One example of an atomic layer etching process in which a surface modification step using acetylacetone (i.e. a β-diketone) and a material detachment step using oxygen on ZnO is described, is presented in the article "New physicochemical approaches in Area-selective Atomic Layer Deposition and Atomic Layer Etching: the case of ZnO", A. Mameli et al., in: Proceedings of the International Conference on Coatings on Glass and Plastics, ICCG 12, TU Wuppertal, June 2018, Technical Session 2: Atmospheric pressure processes.

In general, the second surface modification step is a metal surface modification step with a volatile complexing agent such as a β-diketone like acetylacetonate (HAcAc) or other volatile chemical complexing agents that weaken the chemical bond between the metal and the substrate surface. For the case of Sn, this would be a volatile complex of Sn²⁺(AcAc)₂ that is formed by metal surface chelation. Other chemical complexing agents, typically in the form of organic compounds such as carboxyclic acids, alcohols, etc. may also be used as metal-detaching reactants as well.

All reagents (complexing agents) contain one or more ligands to attach to the metal in a monodentate or multidentate mode, and form chemical bonds with the metal atoms at the surface to form complex compounds and adducts, thus weakening the atomic bonds between the surface metal atoms and the next atom row in the layer below. This surface modification facilitates the evaporation in the next step (e.g. oxygen plasma, see below) of these complexes (e.g. surface β-diketonates, carboxylates, alkoxides, β-diketiminates, amidinates or amides) off the surface or as volatile oxidized fragments thereof.

In the second material detachment step, the actual metal removal takes place by exposure of the optical surface to an O* plasma in order to remove the complexing agent and the C residuals from the optical surface, forming volatile compounds such as Sn²⁺(AcAc) as well as CO, CO₂, H₂O, ...

The surface modification steps and/or the material detachment steps of the atomic layer etching processes, which were described further above, are typically performed in plasma-assisted fashion, but can alternatively or additionally also be performed in temperature-assisted fashion. However, good etching selectivity may already be attained at room temperature. As spatial atomic layer processing is typically performed close to atmospheric pressure and as the plasma radicals recombine extremely fast at these pressures, it is advantageous to generate the plasma as close as possible to the (curved) optical surface of the optical element, e.g. in the atomic layer etching head. The plasma may be generated in the atomic layer processing head e.g. by a dielectric barrier discharge, as explained e.g. in WO 2019/007927 A1 cited above.

In a further variant, the first surface modification step and the first material detachment step are performed in alternation with the second surface modification step and the second material detachment step in the atomic layer etching process. In this case, the first surface modification step A1 and the first material detachment step B1 form a first cycle of a supercycle of the atomic layer processing. Likewise, the second surface modification step A2 and the second material detachment step B2 form a second cycle of the same supercycle of the atomic layer processing. Thus, the ALE process according to the present variant is based on a cleaning supercycle that is composed of the first cleaning cycles (main redox cycles) and the second cleaning cycles (subroutine etch cycles). The second cleaning cycles are nested as a subroutine of the first cleaning cycles and are used for fine cleaning based on chemical adduct formation and are used for removing tightly bound contaminants, e.g. Sn(Oₓ), typically in the final steps of the ALE process. Further features and advantages of the invention emerge from the following description of exemplary embodiments of the invention, with reference to the figures of the drawing, which show details essential to the invention, and from the claims. The individual features may be realized in each case individually by themselves or as a plurality in any desired combination in a variant of the invention.

### Drawing

Exemplary embodiments are represented in the schematic drawing and are explained in the following description. In the drawing:
- Figures 1a-c: show schematic illustrations of an atomic layer processing apparatus having a processing head for processing a curved optical surface,
- Figures 2a-c: show schematic illustrations of a processing head comprising a plasma source and of a holder for holding an optical element having a curved optical surface during atomic layer processing,
- Figures 3a-c: show schematic illustrations of an atomic layer processing apparatus with an atomic layer processing head having an end portion for performing a scanning movement across the curved optical surface of the optical element, not according to the invention,
- Figures 4a,b: show schematic illustrations of the end portion of the atomic layer processing head of Figures 3a-c with three optical sensors, and
- Figures 5a,b: show schematic illustrations of an atomic layer processing head analogous to Figure 3b having three actuators for tilting the end portion relative to a base body of the atomic layer processing head, not according to the invention.

In the following description of the drawings, identical reference signs are used for identical or functionally identical components.

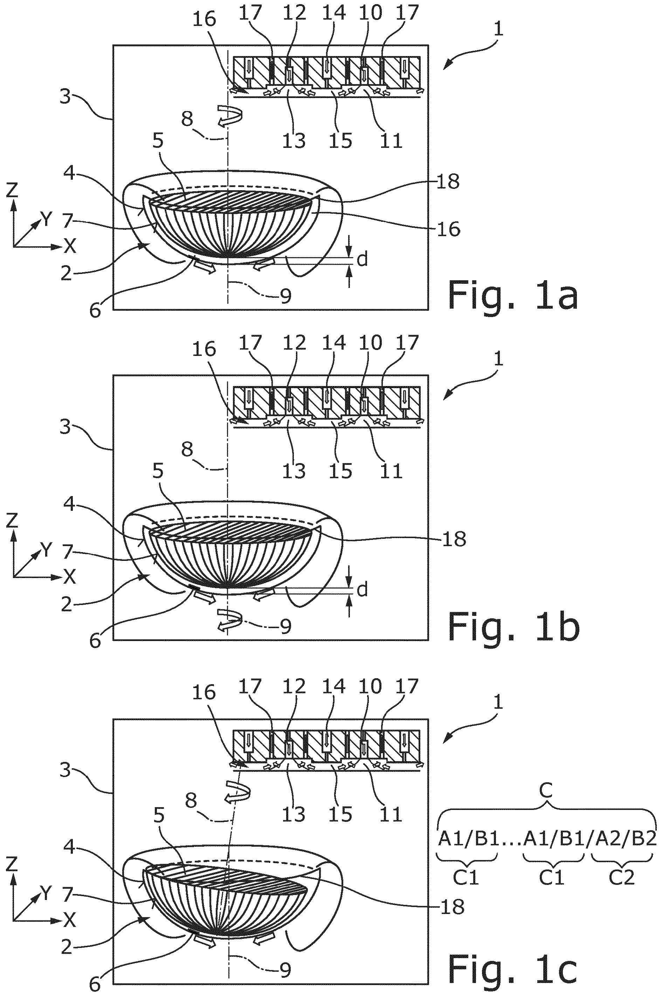

Figures 1a-c schematically show an atomic layer processing apparatus 1 for atomic layer processing of an optical element 2. The atomic layer processing apparatus 1 has a processing chamber 3 in which the optical element 2 is arranged. In Figures 1a-c only the concavely curved optical surface 4 of the optical element 2 is shown. In the present example, the optical element 2 that is processed in the atomic layer processing apparatus 1 is an EUV collector mirror 2 of an EUV lithography apparatus.

The EUV collector mirror 2 is configured to reflect EUV radiation that impinges upon the curved optical surface 4 during exposure operation in the EUV lithography apparatus. For reflecting the EUV radiation, the optical element 2 comprises a multilayer coating that has layers of molybdenum and silicon in alternation, the thicknesses of which are matched to one another such that, at the operating wavelength of the EUV lithography apparatus 1 of approximately 13.5 nm, as high a reflectance as possible is achieved. The curved optical surface 4 is formed on the top side of a capping layer of the reflective coating, which in the example shown is made from Ru. As a result of the continuous use of the reflective optical element 2 in the exposure operation of the EUV lithography apparatus, contaminants 6 (or a contamination layer) have formed on the capping layer. The contaminants 6 include Sn in the example shown, but may also include other chemical elements, in particular metals or metallic compounds. These contaminants 6 cannot be removed, or can be removed only with great difficulty, by way of in-situ cleaning in the EUV lithography apparatus.

To remove the contaminants 6, the EUV collector mirror 2 has been removed from an EUV lithography apparatus and has been transported manually or in automated fashion into the processing chamber 3 of the atomic layer processing apparatus 1. The atomic layer processing apparatus 1 has an atomic layer processing head 5 for performing atomic layer processing of the curved optical surface 4 of the EUV collector mirror 2. For this purpose, the atomic layer processing head 5 has a convexly curved surface 7 that has a geometry (or shape) that is adapted to the concavely curved optical surface 4 of the EUV collector mirror 2. In the present example, the shape or geometry of the convexly curved surface 7 and of the concavely curved optical surface of the EUV collector mirror 2 are practically identical, so that, when both surfaces 4, 7 are brought into direct contact, (virtually) no gap is formed therebetween.

In the present example, the curved optical surface 4 of the EUV collector mirror 2 has an elliptical geometry (i.e. it is an ellipsoid of revolution) and is rotationally symmetric to an axis of (rotational) symmetry 9 that coincides with and axis of (rotational) symmetry 8 of the curved surface 7 of the atomic layer processing head 5 also being an ellipsoid of revolution.

Atomic layer processing is effective only when the processing head 5, more precisely the curved surface 7 thereof, is arranged at a distance d from the curved optical surface 4 of the EUV collector mirror 2 that lies in a distance range of between 20 µm and 300 µm. For keeping the distance d, the atomic layer processing head 5 or the atomic layer processing apparatus 1 may have a plurality of sensors and possibly actuators, as will be described in greater detail below.

The atomic layer processing apparatus 1 of Figures 1a-c is adapted for performing spatial atomic layer processing. For this purpose, a gas pressure in the processing chamber 3 is chosen to be close to atmospheric pressure. For performing spatial atomic layer processing, the atomic layer processing head 5 and the optical element 2 have to be moved relative to each other. For this purpose, the atomic layer processing head 5 can be moved relative to the optical surface 4 of the EUV collector mirror 2 by way of suitable movement devices (not illustrated in Figures 1a-c).

In the examples of Figures 1a-c, the atomic layer processing apparatus 1 is configured to rotate the atomic layer processing head 5 and the EUV collector mirror 2 relative to each other. More specifically, in the example of Figure 1a, the atomic layer processing head 5 can be rotated about the axis of symmetry (of revolution) 8 of the curved surface 7, whereas the optical element 2 is stationary, its axis of symmetry 9 being arranged concentrically to the axis of revolution 8 of the rotating processing head 5.

In the example of Figure 1b, the atomic layer processing head 5 is stationary and the optical element 2 is rotated about its axis of rotational symmetry 9. In the example of Figure 1c, the optical element 2 is stationary, as in Figure 1a, and the rotating processing head 5 can be tilted relative to the curved surface 4 of the EUV collector mirror 2. In the example of Figure 1c, an angle between the axis of rotation 8 of the processing head 5 and the axis of symmetry 9 of the curved surface of the EUV collector mirror 2 can be controlled by the atomic layer processing apparatus 1. It will be understood that in the examples of Figure 1a and Figure 1c, additionally, the EUV collector mirror 2 can also be rotated by way of suitable movement devices about an axis of rotation that coincides with its axis of symmetry 9.

In the atomic layer processing apparatus 1 of Figures 1a-c both atomic layer etching (ALE) and atomic layer deposition (ALD) can be performed. Thus, an ALE-based cleaning process can be extended to or interrupted by an *additive* ALD-based process to refurbish (e.g. Ru deposition) or improve the substrate surface protection layer (e.g. SiO₂ cap layer) of the EUV collector mirror 2 using the relevant chemical vapors in the same equipment, i.e. using one and the same atomic layer processing head 5. In this way, refurbishment of the EUV collector mirror 2 is possible with the atomic layer processing apparatus 1.

The following description of atomic layer processing will be focused on ALE cleaning, more specifically on the removal of Sn contaminants 6 from the curved optical surface 4 of the EUV collector mirror 2. The processing of the curved optical surface 4 by ALD for the deposition of material or material layers will not be described in greater detail herein, as it is well-known in the art.

The atomic layer processing will be described with reference to the sectional view of the processing head 5 shown on the upper right of Figures 1a-c. For ease of representation, the sectional view shows a conventional atomic layer processing head for performing atomic layer processing having a planar surface. However, unless otherwise stated, the elements of the atomic layer head 5 having the curved surface 7 are the same as those of the atomic layer head 5 shown in the sectional view.

In the example shown in Figures 1a-c, the atomic layer processing head 5 has first gas inlet channels 10 for supplying a surface-modifying reactant 11 to the curved surface 4 and second gas inlet channels 12 for supplying a material-detaching reactant 13 to the optical surface 4. The atomic layer processing head 5 also has purge gas inlet channels 14 for supplying an inert purge gas 15 into the intermediate space (gap 16) between the atomic layer processing head 5 and the first and second gas inlet channels 10, 12. The purge gas inlet channels 14 can be used to laterally delimit the region in which the surface-modifying reactant 11 is incident on the curved optical surface 4 and also the region in which the material-detaching reactant 13 is incident on the curved surface 4. The purge gas 15, nitrogen in the present example, together with the respective reactants 11, 13 are extracted from the gap 16 between the atomic layer processing head 5 and the curved optical surface 4 by way of gas exhaust channels 17.

The purge gas 15 can also serve for producing a floating, i.e. frictionless nitrogen gas bearing to provide facilitated movement of the atomic layer processing head 5 in the manner of an air cushion, such that the atomic layer processing head 5 can be positioned at a desired distance d from the curved optical surface 4. As indicated above, the desired distance may be in a range from e.g. 20 µm to 300 µm. For details concerning possible implementations of an atomic layer processing/etching head 4, reference is made to US 9,761,458 B2 cited above.

As can also be gathered from Figures 1a-c, the purge gas 15 also exits the gap 16 at a circular surface at the upper end of the curved surface 4 of the EUV collector mirror 2. This region, i.e. the close proximity to the (concentric) gap 16 between the processing head 5 and the curved optical surface 4 is flushed with the inert gas 15, e.g. nitrogen, thus providing an enclosure or gas curtain 18 to prevent any back-diffusion of outside air into the gap 16 between the curved surface 4 of the EUV collector mirror 2 and the processing head 5.

The surface modification step by way of the surface-modifying reactant 11 and the material detachment step by way of the material-detaching reactant 13 are performed in the example shown in Figures 1a-c at the same time at different locations or regions of the curved optical surface 4. However, by moving the atomic layer processing head 5 and the curved optical surface 4 of the optical element 2 relative to each other, the surface modification step and the material detachment step take place in one and the same location of the optical surface 4 in a temporally successive fashion. Since purging by way of the purge gas 15 is also performed at the same time, the time interval between the two successive steps of the atomic layer etching process is comparatively short. As can be gathered from Figures 1a-c, both the gas injection channel outlets 10, 12, 14 and the gas exhaust channel inlets 17 are slit-shaped and extend parallel to the Y direction of a XYZ coordinate system. In the atomic layer processing head of Figures 1a-c, the gas injection channels 10, 12, 14 as well as the gas exhaust channels 17 are curved, i.e. they extend from a surface of the atomic layer processing head 5 remote from the curved surface 7 of the atomic layer processing head 5 to the curved surface 7 in a curved manner (non-parallel to the Z axis of the XYZ coordinate system). However, not all of the gas injection channels 10, 12, 14 and of the gas exhaust channels 17 extend to the center at the bottom of the curved surface 7 of the atomic layer processing head 5 where the axis of symmetry 8 is located. Rather, as is the case with the planar surface at the top of the atomic layer processing head 5 shown in Figures 1a-c, the curved surface 7 at the bottom of the atomic layer processing head 5 is divided into slides with approximately equal thickness. The curved gas injection/gas exhaust channels 10, 12, 14, 17 are formed in the processing head 5 by 3D printing or by micromachining. The gases 11, 13, 15 needed for the atomic layer processing are typically fed to inlet sections of an injector assembly (not shown in the drawings) that is arranged at the distal end of the processing head 5.

In the following, the atomic layer etching process for removing Sn contaminants 6 from the curved optical surface 4 using the processing head of Figures 1a-c will be described in greater detail:
The ALE process for removing the Sn contaminants is performed in the form of a supercycle C that comprises two atomic layer etching cycles C1, C2 (see Figure 1c).

In the first cycle C1, a first surface modification step A1 using oxygen as the surface-modifying reactant 11 and a first material detachment step B1 using hydrogen as the material-detaching reactant are performed in the atomic layer etching process. The first cycle C1, being a redox cycle, can be used advantageously in particular in an atomic layer etching process in which the contaminants contain tin (Sn) as the contaminating material, and plasma-assisted ALE is performed:
The O*-plasma or O* radicals in the first surface modification step A1 serve to redistribute the Sn contaminants 6, resp., the Sn-film or layer by (pre-oxidizing) and, subsequently, reducing the Sn, and in the subsequent first material detachment step, hydrogen, or more specifically, a hydrogen plasma H* is used as the material-detaching reactant and serves to remove the Sn by conversion into the Sn into the volatile stannane.

The second cycle C2 of the supercycle C of the atomic layer cleaning process described herein comprises a second surface modification step A2 using a chemical complexing agent, in the present example a β-diketone, e.g. acetylacetone, as the surface-modifying reactant 11 and a second material detachment step B2 using oxygen (or an oxygen plasma) as the material-detaching reactant. The second surface modification step A2 and the second material detachment step B2 form the second cycle C2 of the atomic layer etching process.

In general, the second surface modification step A2 is a metal surface modification step with a volatile complexing agent such as a β-diketone like acetylacetonate (HAcAc) or other volatile chemical complexing agents that weaken the chemical bond between the metal and the substrate surface. For the case of Sn, a volatile complex of Sn²⁺(AcAc)₂ is formed by metal surface chelation. Other chemical complexing agents, typically in the form of organic compounds such as carboxyclic acids, alcohols, etc., may also be used as metal-detaching reactants. The second surface modification step A2 facilitates the evaporation in the following second material detachment step B2.

In the second material detachment step B2, the actual metal removal takes place by exposure of the optical surface 4 to an O* plasma in order to remove the complexing agent and the C residuals from the optical surface 4, forming volatile compounds such as Sn²⁺(AcAc) as well as CO, CO₂, H₂O, ...

As indicated above, the first cycle C1 and the second cycle C2 are performed in alternation. More specifically, the second cycle C2 is used as an enhanced cleaning cycle (subroutine etch cycle) for fine cleaning to remove tightly bound contaminants 6, typically in the final steps of the cleaning supercycle C. Figure 1c shows such a cleaning supercycle C that has a number N (e.g. five to ten) of first cleaning cycles C1 and a single second cleaning cycle C2 at the end of the cleaning supercycle C (having the sequence A1/B1/...A1/B1/A2/B2). It will be understood that the cleaning supercycle C may be repeated several times before the atomic layer etching process of the optical surface 4 terminates.

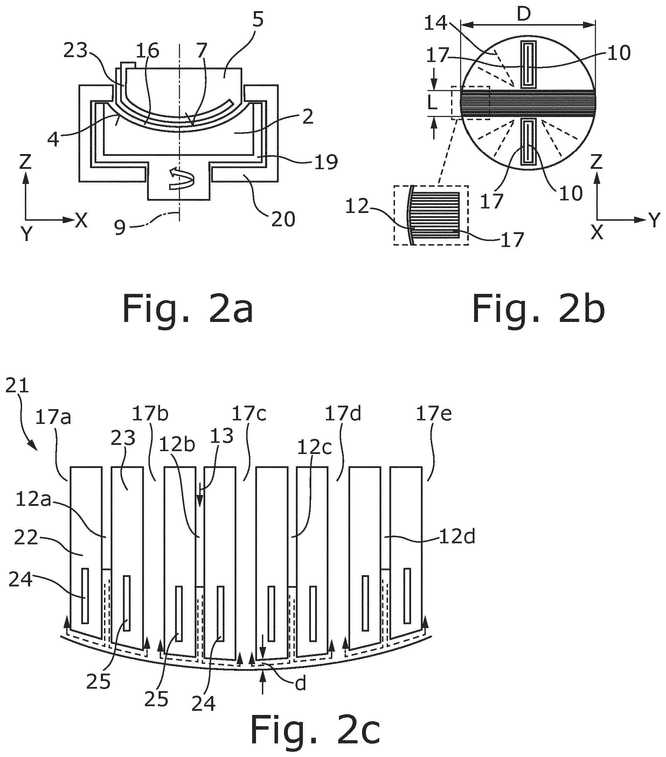

Figures 2a-c show an example of an atomic layer processing head 5 that has a similar design as the atomic layer processing head 5 of Figures 1a-c. The atomic layer processing head 5 of Figures 2a-c also has a convexly curved surface 7 that has a shape that is adapted to the concavely curved surface 4 of the EUV collector mirror 2. The curved surface 7 of the processing head 5 spans the entire surface area of the curved optical surface 4 of the EUV collector mirror 2.

Figure 2a shows the atomic layer processing head 5 and the optical element in the form of the EUV collector mirror 2 in a cross-sectional view. The convexly curved surface 7 of the processing head 5 closely follows the shape of the optical surface 4 of the EUV collecting mirror 2. The EUV collector mirror 2 is arranged in a holder 19 in the interior of the processing chamber 3 (not shown in Figure 2a). The holder 19 can be rotated about a central axis of revolution 9 of the curved surface 4 of the EUV collector mirror 2. For this purpose, the holder 19 is connected to a motor so as to cause the EUV collector mirror 2 to perform a rotational movement during the atomic layer etching process. The holder 19 is arranged in a stationary frame 20 arranged in the processing chamber 3. As is the case with the processing head 5 of Figures 1a-c, a gas bearing is provided for keeping the distance d between the processing head 5 and the curved optical surface 4 in a pre-defined distance range.

As can be seen in the bottom view of the processing head 5 shown in Figure 2b, the processing head 5 has slit-shaped gas injection channels 10, 12, 14:
First gas injection channels 10, well-suited to supply a surface modifying reactant 11, are surrounded by exhaust channels 17 for effectively removing the remainder of reactant having not reacted with the optical surface 4.

Purge gas injection channels 14, well suited for purging and separation of reactants from the first and second injection channels 10 and 12, may be slit-shaped but alternatively made of a series of circular injection holes. The width and number density of the holes can be optimized for both gas separation and gas bearing functions. The width of the holes is typically in the range 0.1-0.5 mm and the relative distance typically in the range 1-5 mm. The gas type used for purging and separation is preferably inert, N₂ or Ar for example.

In contrast to the processing head 5 of Figures 1a-c, the second gas injection channels 12 and the neighbouring gas exhaust channels 17 are arranged in an array-like area that is limited to a region of the processing head 5 having a comparatively small lateral extent L of e.g. about 10-30 mm in comparison to the overall diameter D of the processing head 5 (about 150 mm). In contrast to Figures 1a-c, the second gas injection channels 12 are plasma-activated gas injection channels.

The processing head 5 is thus equipped with a slit-array type of plasma source 21, shown in the example of Figure 2c with four plasma-activated gas injection channels 12a, 12b, 12c and 12d. However, any number in the range from e.g. one to ten is possible. In the slit-array type plasma source 21 shown in more detail in Figure 2c, a number N of slit-like plasma-activated gas injection channels 12a, 12b, 12c and 12d alternates with a number N+1 of gas exhaust channels 17a-e. All plasma-activated gas injection channels 12a, b, c, d have an identical construction.

Because of the high reactivity and, consequently, short life-time of plasma radicals, the effective radical exposure area of the EUV collecting mirror 2 is relatively narrow (<1 mm) when using a single remote plasma injection channel 12. Application of the array of plasma-activated gas injection channels 12a-d results in a wide-area remote plasma source 21 with controlled total exposure width. Using a number N of plasma-activated gas injection channels of N = 4-10, the effective exposure width (lateral extent L) is 4-10 mm.

Increasing the exposure width to values larger than achievable with a single plasma-activated gas injection channel 12 is of critical importance for accomplishing far more effective H₂-N₂ plasma steps. This way, surface contaminants such as adsorbed H₂O can be removed more effectively. This results in an effective reducing radical (H, NH, NH₂) environment even at high gas pressures and low processing temperatures.

A further important benefit of this new type of slit-array plasma source 21 is the insertion of a manifold of interleaved slit-shaped gas exhaust channels 17a-e, allowing for effective removal of reaction products. This will reduce the re-dissociation of reaction products such as SnH₄, Sn(AcAc) and hydrocarbons and thus avoid re-deposition of the metal and carbonaceous contaminant species.

In the present example, the atomic layer etching head 5, more specifically the second, plasma-activated gas injection channels 12a-d, are embodied as Dielectric Barrier Discharge (DBD) plasma sources: The gas injection channels 12a-d are surrounded by two dielectric plates 22, 23 made of ceramic material such as Al₂O₃ or glass. The dielectric plates 22, 23, with embedded film electrodes 24, 25, can be manufactured by using low temperature or high temperatures co-firing techniques (LTCC or HTCC). The dielectric material covering the embedded film electrodes 24, 25 forms a dielectric barrier, allowing for non-thermal plasma formation of the material-detaching reactant 13 passing through the intermediate space between the ceramic plates 22, 23.

In operation, electrodes 24, 25 are coupled to a power supply (not shown) generating an oscillating or repetitively pulsed voltage. For creating an effective plasma-enhanced gas mixture, e.g., molecular oxygen or hydrogen is admixed with an inert carrier gas such as N₂, Ar, He, and Xe.

As can be gathered from Figure 2b, the processing head 5 also has slit-shaped gas exhaust channels 17 adjacent to the surface-modifying gas injection channels 10 in addition to the slit-shaped gas exhaust channels 17a-e adjacent to the material-detaching plasma-activated gas injection channels 12a-d.

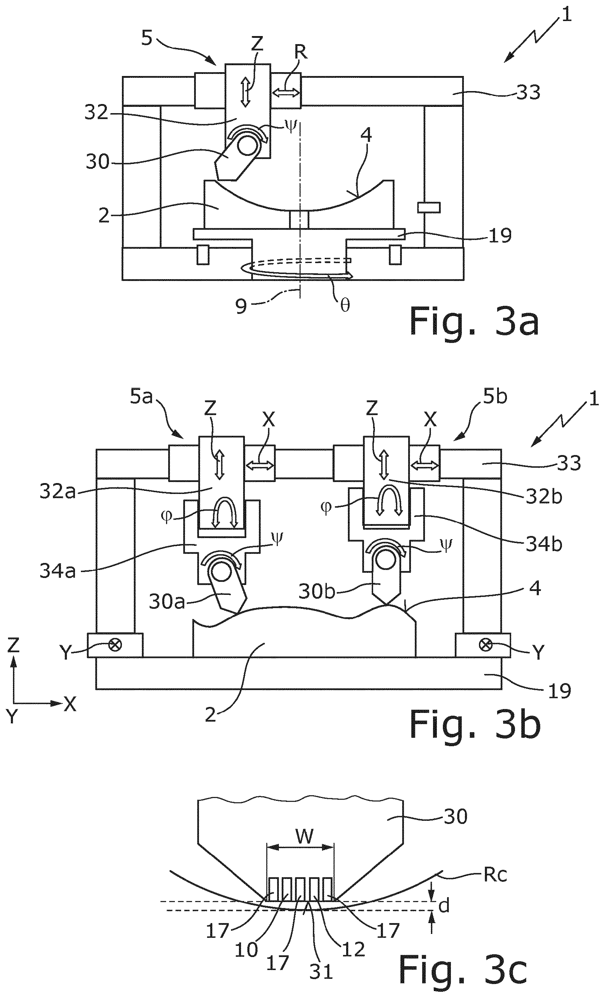

Figures 3a-c show details of an atomic layer processing apparatus 1 that has an atomic layer processing head 5, resp., two atomic layer processing heads 5a, 5b that differ from the atomic layer processing heads 5 of Figures 1a-c and Figure 2a-c in that a respective atomic layer processing head 5, 5a, 5b has an end portion (tip portion) 30 with a planar end surface 31. At the planar end surface 31, a first and a second gas injection channel 10, 12 and three gas exhaust channels 17 terminate. The dimensions of the end portion 30, more precisely of the end surface 31, are small compared to the area covered by the curved surface 4 of the optical element 2. As can be gathered from Figure 3c, the width W of the end surface 31 of the end portion of the processing head 5 is about W = 5 mm, whereas the diameter of the optical surface 4 is about 500 mm.

Figure 3c shows the end portion 30 of the processing head 2 arranged at a (nominal) distance d from the curved optical surface 4, only a (local) radius of curvature Rc being shown in Figure 3c. The nominal gap width d, a minimal gap width dₘᵢₙ, the width W of the end surface 31 and the minimal (local) radius of curvature Rc of the curved optical surface 4 that can be processed by the processing head 2 are related as follows: $Rc \geq \left(0.5 {W}^{2}\right) / \left(d-{d}_{min}\right) .$

For a minimal gap width dₘᵢₙ of 0.1 mm, a nominal gap width d of 0.2 mm, and a source width W of 4 mm, curved optical surfaces 4 having a (local) radius of curvature Rc of 40 mm or more may be processed by atomic layer processing using the processing head 2.

For performing atomic layer processing of an optical surface 4 having a (local) curvature radius Rc satisfying the above relation, the apparatus 1 is configured to move the end portion 30 of the atomic layer processing head 5 (and also the processing head 5) relative to the curved optical surface 4 of the optical element 2 in a scanning manner.

In the apparatus 1 shown in Figure 3a, the optical surface 4 is aspherical, more precisely, forms an ellipsoid that has a rotational symmetry about its central axis 9. The optical element 2 is mounted on a holder 19 that can be rotated about the central axis 9 of the optical element 2 (with rotation angle θ). The processing head 5 is mounted on a portal 33 and can be translated in a radial direction R with respect to the central axis 9 of the optical element 2. The processing head 5, to be more precise, a main body 32 of the processing head 5, can be moved in the vertical direction Z relative to the portal 33. The end portion 30 of the processing head 5 can be tilted about an axis that is perpendicular to the radial direction R about an angle ψ relative to the main body 32. Thus, the apparatus 1 shown in Figure 3a allows movement of the end portion 30 of the processing head 5 with four degrees of freedom (R, Z, θ, ψ).

Figure 3b shows an apparatus 1 that comprises two processing heads 5a, 5b being of identical construction. In the example of Figure 3b, the optical element 2 has an optical surface 4 in the form of a free-form surface and is arranged on a stationary holder 19 (or support). Each of the two processing heads 5a, 5b has an end portion 30a, 30b that can be moved in a scanning manner relative to the optical surface 4 of the optical element 2. Both processing heads 5a, 5b, more specifically the base bodies 30a, 30b thereof, can be moved independently from each other along a portal 33 in an X direction of an XYZ coordinate system.

The base bodies 32a, 32b of the two processing heads 5a, 5b can also be moved in the vertical direction Z independently from one another. A respective intermediate portion 34a, 34b of the processing heads 5a, 5b is mounted on the base bodies 32a, 32b so as to be rotatable about an axis of rotation extending in the X direction (with rotation angle φ) The end portion 30a, 30b of the respective processing head 5a, 5b is mounted on the intermediate portion 34a, 34b so as to be rotatable about an axis of rotation that extends in the Y direction of the XYZ coordinate system. The portal 33 can be moved relative to the holder 19 of the optical element 2 in the Y direction. In this way, both end portions 30a, 30b of the processing heads 5a, 5b are moveable in a scanning manner relative to the optical surface 4 with five degrees of freedom (X, Y, Z, φ, ψ).

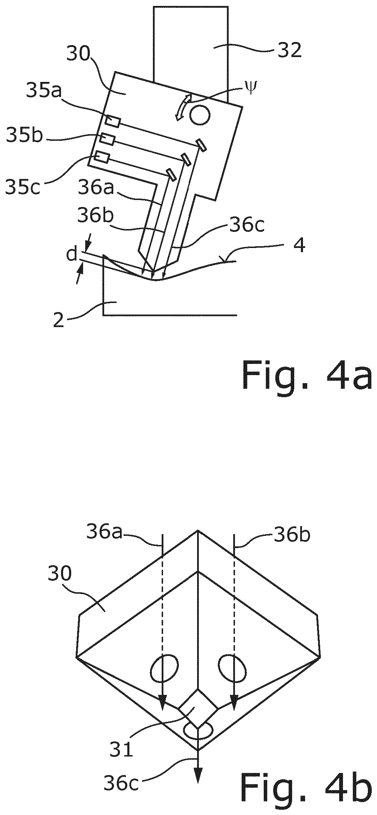

Figures 4a,b show a detail of the processing head 5 of Figure 3a having an end portion 30 with an integrated sensor array comprising three distance sensors 35a-c for directing a respective measuring beam 36a-c to the curved optical surface 4 of the optical element 2. As can be seen in Figure 4b, the three measuring beams 36a-c pass through holes in the end portion 30 of the measuring head 5 and strike the optical surface 4 at three locations arranged in a triangle. In this way, both the orientation (rotation angle ψ) and the distance d between the end portion 30 of the processing head 5 and the curved optical surface 4 of the optical element 2 can be determined with high precision, thus allowing to control the distance d in the pre-defined distance range specified above. For the purpose of distance control as well as for other purposes, the apparatus 1 or the processing head 5 has a control device (not shown) being implemented as a suitable hardware and/or software element.

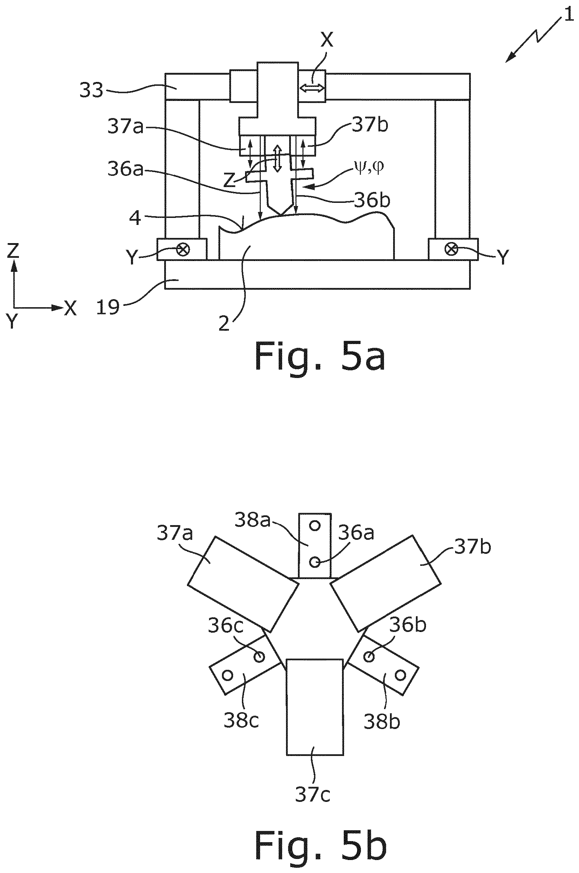

Figures 5a,b show an apparatus 1 that allows rotation of the end portion 30 of the processing head 5 in five degrees of freedom X, Y, Z, φ, ψ, as is the case with the processing heads 5a, 5b of Figure 3b. In this way, the smallest possible processing gap between the curved optical surface 4 and the end portion 30 of the processing head 5 can be created. The processing head 5 of Figures 5a,b has three Lorentz actuators 37a-c that act on three folded leaf springs 38a-c to allow for rotation of the end portion 30 of the processing head 5 in two rotational degrees of freedom φ, ψ and in one translational degree of freedom (z direction) relative to the main body 32 of the processing head 5. In this way, both the orientation (angles φ, ψ) and the distance (in the z direction) between the end portion 30 of the processing head 5 of Figures 5a,b and the curved optical surface 4 of the optical element 2 can be adjusted.

The folded leaf springs 38a-c are used for fixing the two other translational degrees of freedom (in the X direction and in the Y direction). As in Figure 3b, the processing head 5 can be moved in the X direction along a portal 33 and the portal 33 can be moved relative to the holder 19 of the optical element 2 in the Y direction to allow movement of the processing head 5 in a scanning manner relative to the curved optical surface 4. As can also be gathered from Figures 5a,b, the processing head 5 has the three sensors 36a-c of Figures 4a,b to allow determination of the orientation and the distance between the end portion 30 of the processing head 5 and the curved optical surface 4 of the optical element 2.

Instead of the reflective optical element 2 in the form of an EUV collector mirror described above, it is also possible to make use of the apparatus 1 to remove contaminants 6 from other reflective optical elements, in particular from optical elements configured for reflecting EUV radiation, for example from what are known as "grazing-incidence" mirrors, which have a reflective coating that may consist only of a single layer.

## Claims

1. Atomic layer processing apparatus (1) for spatial atomic layer processing of an optical surface (4) of an optical element (2) preferably configured to reflect EUV radiation, the apparatus (1) comprising:
a processing chamber (3), and
at least one processing head (5, 5a,b) configured for atomic layer processing of the optical surface (4) of the optical element (2) within the processing chamber (3),
wherein the at least one processing head (5, 5a,b) is suitable for performing atomic layer processing of a curved optical surface (4) of the optical element (2),
**characterized in that**
the atomic layer processing head (5) comprises a curved surface (7) having a geometry that is adapted to the curved optical surface (4) of the optical element (2).

2. The apparatus according to claim 1, being adapted to keep a distance (d) of the at least one processing head (5, 5a,b) from the curved optical surface (4) in a distance range between 20 µm and 300 µm during the atomic layer processing.

3. The apparatus according to claim 1 or 2, being configured to rotate the atomic layer processing head (5) and the curved surface (4) of the optical element (2) relative to each other.

4. The apparatus according to claim 3, being configured to tilt the curved surface (7) of the atomic layer processing head (5) relative to the curved surface (4) of the optical element (2).

5. The apparatus according to any one of the preceding claims, wherein the atomic layer processing head (5) comprises at least one of slit-shaped gas injection channels (10, 12, 14) and slit-shaped gas exhaust channels (17).

6. The apparatus according to any one of the preceding claims, wherein the atomic layer processing head (5) comprises a plasma source (21) having an array of slit-shaped plasma-activated gas injection channels (12a-d).

7. The apparatus according to any one of the preceding claims, further comprising: at least one sensor (35a-c) for determining an orientation (φ, ψ) and/or a distance (d) between the processing head (5) and the curved surface (4) of the optical element (2).

8. The apparatus according to any one of the preceding claims, further comprising: at least one actuator (37a-c) for adjusting an orientation (φ, ψ) and/or a distance (d) between the processing head (5) and the curved surface (4) of the optical element (2).

9. Method for spatial atomic layer processing of an optical surface (4) of an optical element (2), preferably configured to reflect EUV radiation, comprising: performing a spatial atomic layer etching process for removing contaminants (6) from the curved optical surface (4) of the optical element (2) in an atomic layer processing apparatus (1) in accordance with one of the preceding claims, wherein the spatial atomic layer etching process comprises: exposing the curved optical surface (4) to a surface-modifying reactant (11) in a surface modification step (A1, A2), and exposing the curved optical surface (4) to a material-detaching reactant (13) in a material detachment step (B1, B2).

10. Method according to claim 9, wherein the spatial atomic layer processing further comprises:
performing a spatial atomic layer deposition process for depositing material on the curved optical surface (4) of the optical element (2).

11. Method according to any one of claims 9 and 10, in which a first surface modification step (A1) using oxygen as the surface-modifying reactant (11) and preferably a first material detachment step (B1) using hydrogen as the material-detaching reactant (13) are performed in the spatial atomic layer etching process.

12. Method according to any one of claims 9 to 11, in which a second surface modification step (A2) using a chemical complexing agent, preferably using a β-diketone, in particular acetylacetone, as the surface-modifying reactant (11) and preferably a second material detachment step (B2) using oxygen as the material-detaching reactant (13) are performed in the spatial atomic layer etching process.

13. Method according to claims 11 and 12, wherein the first surface modification step (A1) and the first material detachment step (B1) are performed in alternation with the second surface modification step (A2) and the second material detachment step (B2) in the spatial atomic layer etching process.

## Patentansprüche

1. Atomlagenverarbeitungsvorrichtung (1) zur räumlichen Atomlagenverarbeitung einer optischen Oberfläche (4) eines optischen Elements (2), vorzugsweise dazu ausgelegt, EUV-Strahlung zu reflektieren, wobei die Vorrichtung (1) Folgendes umfasst:
eine Verarbeitungskammer (3), und
mindestens einen Verarbeitungskopf (5, 5a, b), der zur Atomlagenverarbeitung der optischen Oberfläche (4) des optischen Elements (2) innerhalb der Verarbeitungskammer (3) ausgelegt ist,
wobei der mindestens eine Verarbeitungskopf (5, 5a, b) zum Durchführen von Atomlagenverarbeitung einer gekrümmten optischen Oberfläche (4) des optischen Elements (2) geeignet ist,
**dadurch gekennzeichnet, dass**
der Atomlagenverarbeitungskopf (5) eine gekrümmte Oberfläche (7) mit einer Geometrie umfasst, die an die gekrümmte optische Oberfläche (4) des optischen Elements (2) angepasst ist.

2. Vorrichtung nach Anspruch 1, die dazu angepasst ist, während der Atomlagenverarbeitung einen Abstand (d) des mindestens einen Verarbeitungskopfs (5, 5a, b) von der gekrümmten optischen Oberfläche (4) in einem Abstandsbereich zwischen 20 µm und 300 µm zu halten.

3. Vorrichtung nach Anspruch 1 oder 2, die dazu ausgelegt ist, den Atomlagenverarbeitungskopf (5) und die gekrümmte Oberfläche (4) des optischen Elements (2) relativ zueinander zu rotieren.

4. Vorrichtung nach Anspruch 3, die dazu ausgelegt ist, die gekrümmte Oberfläche (7) des Atomlagenverarbeitungskopfs (5) relativ zu der gekrümmten Oberfläche (4) des optischen Elements (2) zu kippen.

5. Vorrichtung nach einem der vorhergehenden Ansprüche, wobei der Atomlagenverarbeitungskopf (5) mindestens einen von schlitzförmigen Gasinjektionskanälen (10, 12, 14) und schlitzförmigen Gasabführkanälen (17) umfasst.

6. Vorrichtung nach einem der vorhergehenden Ansprüche, wobei der Atomlagenverarbeitungskopf (5) eine Plasmaquelle (21) mit einem Array von schlitzförmigen plasmaaktivierten Gasinjektionskanälen (12a-d) umfasst.

7. Vorrichtung nach einem der vorhergehenden Ansprüche, die ferner Folgendes umfasst: mindestens einen Sensor (35a-c) zum Bestimmen einer Orientierung (φ, ψ) und/oder eines Abstands (d) zwischen dem Verarbeitungskopf (5) und der gekrümmten Oberfläche (4) des optischen Elements (2).

8. Vorrichtung nach einem der vorhergehenden Ansprüche, die ferner Folgendes umfasst: mindestens einen Aktuator (37a-c) zum Einstellen einer Orientierung (φ, ψ) und/oder eines Abstands (d) zwischen dem Verarbeitungskopf (5) und der gekrümmten Oberfläche (4) des optischen Elements (2).

9. Verfahren zur räumlichen Atomlagenverarbeitung einer optischen Oberfläche (4) eines optischen Elements (2), vorzugsweise dazu ausgelegt, EUV-Strahlung zu reflektieren, umfassend:
Durchführen eines räumlichen Atomlagenätzprozesses zum Entfernen von Verunreinigungen (6) von der gekrümmten optischen Oberfläche (4) des optischen Elements (2) in einer Atomlagenverarbeitungsvorrichtung (1) nach einem der vorhergehenden Ansprüche, wobei der räumliche Atomlagenätzprozess Folgendes umfasst:
Aussetzen der gekrümmten optischen Oberfläche (4) einem oberflächenmodifizierenden Reaktanten (11) in einem Oberflächenmodifikationsschritt (A1, A2), und
Aussetzen der gekrümmten optischen Oberfläche (4) einem materialablösenden Reaktanten (13) in einem Materialablöseschritt (B1, B2).

10. Verfahren nach Anspruch 9, wobei die räumliche Atomlagenverarbeitung ferner Folgendes umfasst:
Durchführen eines räumlichen Atomlagenabscheidungsprozesses zum Abscheiden von Material auf der gekrümmten optischen Oberfläche (4) des optischen Elements (2).

11. Verfahren nach einem der Ansprüche 9 und 10, wobei in dem räumlichen Atomlagenätzprozess ein erster Oberflächenmodifikationsschritt (A1), der Sauerstoff als den oberflächenmodifizierenden Reaktanten (11) verwendet, und vorzugsweise ein erster Materialablöseschritt (B1), der Wasserstoff als den materialablösenden Reaktanten (13) verwendet, durchgeführt werden.

12. Verfahren nach einem der Ansprüche 9 bis 11, wobei in dem räumlichen Atomlagenätzprozess ein zweiter Oberflächenmodifikationsschritt (A2), der als den oberflächenmodifizierenden Reaktanten (11) einen chemischen Komplexbildner verwendet, vorzugsweise ein β-Diketon verwendet, insbesondere Acetylaceton, und vorzugsweise ein zweiter Materialablösungsschritt (B2), der Sauerstoff als materialablösenden Reaktanten (13) verwendet, durchgeführt werden.

13. Verfahren nach Anspruch 11 und 12, wobei in dem räumlichen Atomlagenätzprozess der erste Oberflächenmodifikationsschritt (A1) und der erste Materialablöseschritt (B1) abwechselnd mit dem zweiten Oberflächenmodifikationsschritt (A2) und dem zweiten Materialablöseschritt (B2) durchgeführt werden.

## Revendications

1. Appareil de traitement par couches atomiques (1) pour le traitement spatial par couches atomiques d'une surface optique (4) d'un élément optique (2) de préférence conçu pour réfléchir le rayonnement EUV, l'appareil (1) comprenant :
une chambre de traitement (3), et
au moins une tête de traitement (5, 5a,b) conçue pour le traitement par couches atomiques de la surface optique (4) de l'élément optique (2) à l'intérieur de la chambre de traitement (3),
dans lequel l'au moins une tête de traitement (5, 5a,b) convient pour réaliser un traitement par couches atomiques d'une surface optique incurvée (4) de l'élément optique (2),
**caractérisé en ce que**
la tête de traitement par couches atomiques (5) comprend une surface incurvée (7) dont la géométrie est adaptée à la surface optique incurvée (4) de l'élément optique (2).

2. Appareil selon la revendication 1, adapté pour maintenir une distance (d) entre l'au moins une tête de traitement (5, 5a, b) et la surface optique incurvée (4) dans une fourchette de distances comprises entre 20 µm et 300 µm pendant le traitement par couches atomiques.

3. Appareil selon la revendication 1 ou 2, conçu pour faire tourner la tête de traitement par couches atomiques (5) et la surface incurvée (4) de l'élément optique (2) l'une par rapport à l'autre.

4. Appareil selon la revendication 3, conçu pour incliner la surface incurvée (7) de la tête de traitement par couches atomiques (5) par rapport à la surface incurvée (4) de l'élément optique (2).

5. Appareil selon l'une quelconque des revendications précédentes, dans lequel la tête de traitement par couches atomiques (5) comprend des canaux d'injection de gaz en forme de fente (10, 12, 14) et/ou des canaux d'échappement de gaz en forme de fente (17).

6. Appareil selon l'une quelconque des revendications précédentes, dans lequel la tête de traitement par couches atomiques (5) comprend une source de plasma (21) comportant un réseau de canaux d'injection de gaz activée par plasma en forme de fente (12a-d).

7. Appareil selon l'une quelconque des revendications précédentes, comprenant en outre : au moins un capteur (35a-c) destiné à déterminer une orientation (φ, ψ) et/ou une distance (d) entre la tête de traitement (5) et la surface incurvée (4) de l'élément optique (2).

8. Appareil selon l'une quelconque des revendications précédentes, comprenant en outre : au moins un actionneur (37a-c) destiné à régler une orientation (φ, ψ) et/ou une distance (d) entre la tête de traitement (5) et la surface incurvée (4) de l'élément optique (2).

9. Procédé de traitement spatial par couches atomiques d'une surface optique (4) d'un élément optique (2) de préférence conçu pour réfléchir le rayonnement EUV, comprenant :
la réalisation d'un processus de gravure spatiale par couches atomiques pour éliminer des contaminants (6) de la surface optique incurvée (4) de l'élément optique (2) dans un appareil de traitement par couches atomiques (1) selon une des revendications précédentes, le processus de gravure spatiale par couches atomiques comprenant :
l'exposition de la surface optique incurvée (4) à un réactif de modification de surface (11) dans une étape de modification de surface (A1, A2), et
l'exposition de la surface optique incurvée (4) à un réactif de détachement de matériau (13) dans une étape de détachement de matériau (B1, B2).

10. Procédé selon la revendication 9, dans lequel le traitement spatial par couches atomiques comprend en outre :
la réalisation d'un processus de dépôt spatial de couches atomiques pour déposer un matériau sur la surface optique incurvée (4) de l'élément optique (2).

11. Procédé selon l'une quelconque des revendications 9 et 10, dans lequel une première étape de modification de surface (A1) utilisant de l'oxygène comme réactif de modification de surface (11) et de préférence une première étape de détachement de matériau (B1) utilisant de l'hydrogène comme réactif de détachement de matériau (13) sont réalisées lors du processus de gravure spatiale par couches atomiques.

12. Procédé selon l'une quelconque des revendications 9 à 11, dans lequel une deuxième étape de modification de surface (A2) utilisant un agent complexant chimique, de préférence utilisant une β-dicétone, en particulier de l'acétylacétone, comme réactif de modification de surface (11) et de préférence une deuxième étape de détachement de matériau (B2) utilisant de l'oxygène comme réactif de détachement de matériau (13) sont réalisées lors du processus de gravure spatiale par couches atomiques.

13. Procédé selon les revendications 11 et 12, dans lequel la première étape de modification de surface (A1) et la première étape de détachement de matériau (B1) sont réalisées en alternance avec la deuxième étape de modification de surface (A2) et la deuxième étape de détachement de matériau (B2) lors du processus de gravure spatiale par couches atomiques.
